# EUROPEAN PATENT APPLICATION

(11) **EP 4 636 904 A1**
(43) Date of publication of application: **22.10.2025**
(21) Application number: 25168589.7
(22) Date of filing: 04.04.2025
(51) Int. Cl.: H01M 10/42, H01M 10/44, H01M 10/48, H01M 50/204, H01M 50/264, H01M 50/502

(54) **BATTERY PACK**

(30) Priority: 17.04.2024 KR 20240051168
(71) Applicant: SAMSUNG SDI CO., LTD., Yongin-si, Gyeonggi-do 17084 (KR)
(72) Inventor: Park, Kyunghoon, Yongin-si, Gyeonggi-do 17084 (KR)
(74) Representative: Gulde & Partner

(57) **Abstract**

A battery pack (1) includes battery modules (4) configured to be individually replaceable, a frame (30) configured to accommodate the battery modules (4), and a battery control module (2) outside the battery modules (4) and configured to control charging and discharging of the battery modules (4). Each of the battery modules (4) includes a recording element (62) configured to record a charging cycle of the respective battery module (4).

## Description

### BACKGROUND

### 1. Field

One or more embodiments relate to a battery pack.

### 2. Description of the Related Art

Secondary batteries can be charged and discharged multiple times to enable repeated use. Secondary batteries are used as energy sources for mobile devices, electric vehicles, hybrid vehicles, electric bicycles, uninterruptible power supplies, etc. Also, depending on the type of external devices to which secondary batteries are applied, the secondary batteries may be used in the form of a battery or a module in which a plurality of batteries are connected and bundled into a single unit.

The above information disclosed in this Background section is for enhancement of understanding of the background of the present disclosure, and therefore, it may contain information that does not constitute prior art.

### SUMMARY

One or more embodiments include a battery pack including at least one battery module that includes a recording element configured to record a charging cycle.

One or more embodiments include a battery pack in which battery control modules and battery modules may be replaceable independently of each other.

Additional aspects will be set forth in part in the description which follows and, in part, will be apparent from the description, or may be learned by practice of the presented embodiments of the present disclosure.

According to one or more embodiments, a battery pack includes battery modules configured to be individually replaced or replaceable, a frame configured to accommodate the battery modules, and a battery control module outside the battery modules and configured to control charging and discharging of the battery modules. Each of the battery modules includes a recording element configured to record a charging cycle of the battery module, e.g. the battery module that includes the recording element. Hence, the condition and e.g. the current condition of each of the battery modules can be considered when using the battery module with the battery pack, even if the batter module has not been used with the battery pack before or has be used otherwise, e.g. with another battery pack, for some time. Due to this, the maximum capacity can be utilized when charging the battery modules.

The battery modules may be accommodated in the frame and overlap each other in a height direction. Overlapping in the height direction may mean that the battery modules are arranged one after the other in the height direction. Overlapping in the height direction may mean that a projection in the height direction of at least one of the battery modules overlaps at least another one of the battery modules. The height direction may also be considered by a stacking direction, in which the battery modules may be stacked one after the other. The height direction may be the vertical direction or the horizontal direction when using the battery pack. An advantage of this embodiment may be that the battery modules require a small volume and/or footprint.

The battery modules may be accommodated in the frame. The battery modules may be detachable in a first direction. The first direction may be perpendicular to the height direction. An advantage of this embodiment may be that the battery modules can be easily removed from and/or placed in the batter pack, e.g. in the frame.

Each of the battery modules may be configured to transmit information about the charging cycle recorded in the recording element to the battery control module. An advantage of this embodiment may be that the battery control module can considered the current of the battery modules when controlling the battery modules.

The plurality of battery modules may be configured to be detachable from the frame independently of the battery control module. An advantage of this embodiment may be that the battery modules can be detached easily and/or that in case that a battery module needs to be replaced, e.g. due to wear and tear, merely the battery module and not also the battery control module needs to be replaced, which reduces costs.

The battery control module may be on a front surface of the frame. An advantage of this embodiment may be that the battery control module may be easily accessible.

The battery control module may overlap the battery modules in the first direction. Overlapping in the first direction may mean that the battery control module is arranged before or after at least selected or some of the battery modules in the first direction. Overlapping in the first direction may mean that a projection in the first direction of the battery control module overlaps at least selected or some of the battery modules. An advantage of this embodiment may be that a user can easily access the battery control module.

The battery control module may include two or more battery control modules. The control modules may be electrically connected to the battery modules. An advantage of this embodiment may be that a user can easily understand which of the battery control modules is allocated to which of the battery modules.

The battery pack may further include a module bus bar. The module bus bar may be configured to electrically connect the battery modules to each other. The module bus bar may be between and e.g. arranged beetween the battery modules and the battery control modules. An advantage of this embodiment may be that the module bus bar is protected from being contacted by a user while interconnecting the battery modules in a compact manner.

The battery pack may further include a battery management unit configured to selectively charge or discharge at least some of the battery modules. An advantage of this embodiment may be that each of the battery modules can be charged or discharged considering its condition and e.g. its current condition.

The battery management unit may be on the frame. An advantage of this embodiment may be that the battery management unit can be easily accessed without blocking access to the frame and/or the battery modules and/or the at least one battery control module.

The recording element may be configured to record the number of charging cycles. The recording element may be configured to record electrical parameters and/or thermal parameters of the battery module during a charging cycle. The electrical parameters may be charging current, charging voltage and/or internal resistance of the battery module. The thermal parameters may comprise a temperature and/or a temperature progression or trend of the battery module and/or an ambient temperature of the battery module before, during and/or after the charging cycle. The recording element may be configured to record historical data regarding previous charging cycles. The battery modules may be provided with the recording elements, which may store a record of charging cycles to allow for independent replacement of battery modules and battery control modules without losing charging history data.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a perspective view of a battery pack according to embodiments;
FIG. 2 is an exploded perspective view of the battery pack according to embodiments;
FIG. 3 is an exploded perspective view showing a process of replacing a battery module in the battery pack according to embodiments;
FIG. 4 is an exploded perspective view of the battery module according to embodiments;
FIG. 5 is a diagram showing a controller according to embodiments; and
FIG. 6 is a diagram showing a recording module according to embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," if preceding a list of elements, modify the entire list of elements and do not modify the individual elements of the list.

Hereinafter, embodiments are described in detail with reference to the accompanying drawings. First of all, terms or words used in the descriptions and claims should not be restrictively interpreted as ordinary meanings or dictionary-based meanings, but should be interpreted as meanings and concepts conforming to the technical scope of the present disclosure on the basis of the principle that inventors can properly define the concept of terms to describe and explain their disclosures in the best ways. Therefore, the embodiments described in this specification and the configurations illustrated in the drawings are only preferred embodiments of the present disclosure, and may not describe the technical idea thoroughly. For example, it should be understood that various modifications that can be substituted for the embodiments might be provided at the filing date of the present application. Also, it will be further understood that the terms "comprise or include" and/or "comprising or including," if used in this specification, specify the presence of stated features, numbers, steps, operations, members, elements, and/or groups thereof, but do not preclude the presence or addition of one or more other features, numbers, steps, operations, members, elements, and/or groups thereof. Also, the use of "may" if describing embodiments of the present disclosure refers to "one or more embodiments of the present disclosure."

Also, in order to facilitate understanding of the present disclosure, the accompanying drawings are not drawn to actual scales and the dimensions of some components may be exaggerated. Also, the same reference numbers may be assigned to the same components in different embodiments.

The statement that two comparison objects are 'the same' indicates that these objects are 'substantially the same.' Therefore, the expression that objects are substantially same may include cases in which the deviation between these objects is considered low in the art, for example, less than 5 %. Also, if some parameters are uniform in a certain region, this may indicate that these parameters are uniform in terms of an average.

Although the terms "first," "second," etc. may be used herein to describe various elements, these elements should not be limited by these terms. These terms are only used to distinguish one component from another component, and a first component may be referred to as a second component unless specifically otherwise stated.

Throughout the specification, each component may be singular or plural unless specifically otherwise stated.

If one component is placed "above (or below)" another component or "on (or beneath)" another component, this may indicate that not only can one component be disposed in contact with the upper (or lower) surface of another component, but also an intervening component can be located between another component and one component disposed above (or below) another component.

Also, if one component is described as being "connected," "coupled," or "linked" to another component, these components may be directly connected or linked to each other. However, this should also be understood that an intervening component may be "interposed" between one component and another component or these components may be "connected," "coupled," or "linked" to each other via the intervening component. Also, if one part is described as being electrically coupled to another part, this includes not only a case, in which these parts are directly connected to each other, but also a case in which these parts are connected to each other with an intervening part therebetween.

Throughout the specification, the expression "A and/or B" may represent A, B, or A and B unless specifically otherwise stated. For example, the expression "and/or" includes all or any combination of a plurality of listed items. The expression "C to D" may represent C or more and D or less unless specifically otherwise stated.

Hereinafter, a battery pack 1 according to embodiments is described with reference to the accompanying drawings.

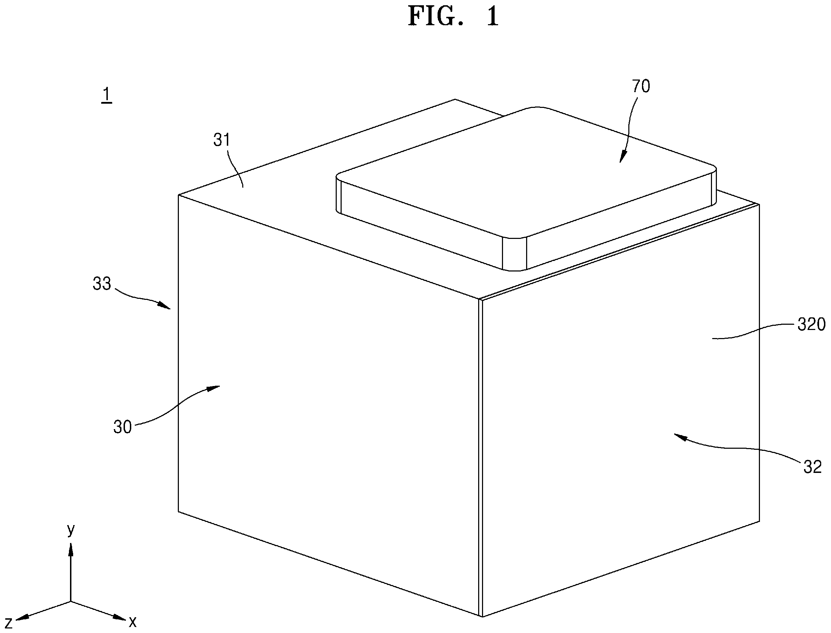

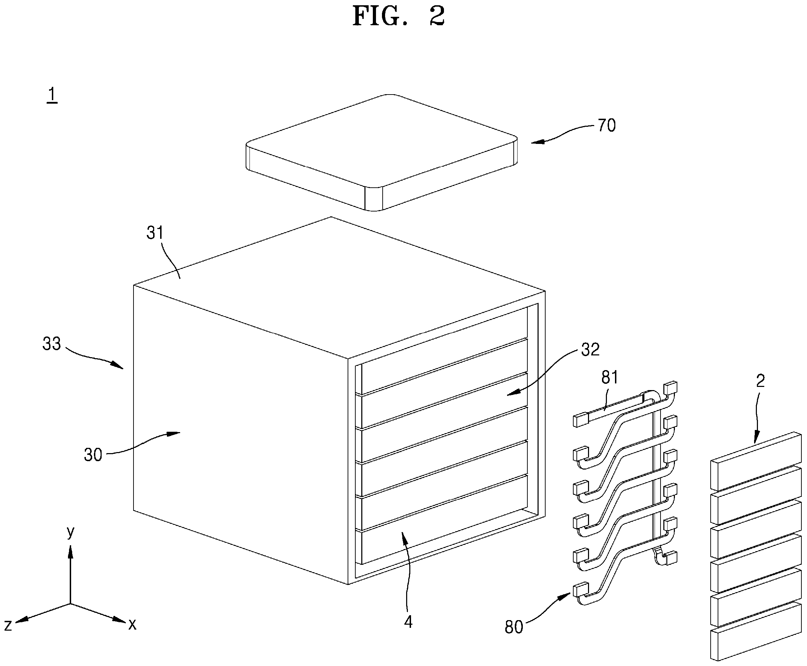

FIG. 1 is a perspective view of a battery pack 1 according to embodiments. FIG. 2 is an exploded perspective view of the battery pack 1 according to embodiments.

Referring to FIGS. 1 and 2, the battery pack 1 according to embodiments may include a battery module 4. According to embodiments, the battery pack 1 may include a plurality of battery modules 4. The battery pack 1 may include a frame 30 configured to accommodate the battery module 4. The frame 30 may accommodate the plurality of battery modules 4. According to embodiments, the battery module 4 may be detachably or removably accommodated in the frame 30. According to embodiments, the plurality of battery modules 4 may be detachably or removably accommodated in the frame 30.

The battery pack 1 according to embodiments may include a front cover 320 that covers the plurality of battery modules 4 in a direction toward the front surface of the frame 30. The battery pack 1 may include a rear cover that covers the plurality of battery modules 4 in a direction toward the rear surface of the frame 30.

The plurality of battery modules 4 according to embodiments may be accommodated in the frame 30 and may overlap each other in a height direction y (i.e., the battery modules 4 may be stacked in the height direction y). The plurality of battery modules 4 may be arranged inside the frame 30 and overlap each other in the height direction y. The height direction y may be a direction toward the upper portion of the battery pack 1. However, the plurality of battery modules 4 may be accommodated inside the frame 30 in any other suitable manner.

In the following description, the plurality of battery modules 4 may be referred to as a battery module 4. The plurality of battery modules 4 may be described by example of a battery module 4. Unless explicitly referred to as a plurality of battery modules 4, the battery module 4 may represent a plurality of battery modules 4 or a single battery module 4.

The battery pack 1 according to embodiments may include a module bus bar 80. The module bus bar 80 may electrically connect the battery modules 4 to each other. The module bus bar 80 may be on a frame front surface 32 of the frame 30. The frame front surface 32 may be one surface of the frame 30 that faces in a direction perpendicular to the height direction y of the battery pack 1. The module bus bar 80 may electrically connect any two battery modules 4 arranged adjacent to each other in the height direction y. A connection portion 81 in the module bus bar 80 may electrically connect any two battery modules 4 that are furthest apart from each other in the height direction y (i.e., an uppermost and a lower most battery module 4). However, the above way by which the module bus bar 80 electrically connects the plurality of battery modules 4 to each other is only an embodiment, and the arrangement of the module bus bar 80 is not limited thereto.

The battery pack 1 according to embodiments may include a battery control module 2. The battery control module 2 may be configured to control charging and discharging of the battery module 4. The battery control module 2 may be configured to control the charging of the battery module 4 to prevent (or at least mitigate) excessive voltage from being supplied to the battery module 4. The battery control module 2 may be configured to control the charging of the battery module 4 to prevent (or at least mitigate) power from being supplied to the battery module 4 in response to a state of charge (SOC) of the battery module 4 being excessively high. The battery control module 2 may be configured to control the discharging of the battery module 4 to prevent (or at least mitigate) power from being discharged from the battery module 4 in response to the SOC of the battery module 4 being excessively low. However, the functions of the battery control module 2 are not limited to those described above. In addition to the functions described above, the battery control module 2 may have functions that may improve (increase) the reliability and lifespan of the battery module 4. For example, the battery control module 2 may limit the maximum of energy to be charged in a battery module, in all battery modules or in selected of the battery modules and for example individually for each of the battery modules.

According to embodiments, the battery control module 2 may include a plurality of battery control modules 2. The plurality of battery control modules 2 may respectively correspond to the plurality of battery modules 4. Any one battery control module 2 among the plurality of battery control modules 2 may correspond to any one battery module 4 among the plurality of battery modules 4. For example, each of the battery control modules 2 may be assigned to one and e.g. a single one of the battery modules 4.

In the following description, the plurality of battery control modules 2 may be referred to as a battery control module 2. The plurality of battery control modules 2 may be described by example of a battery control module 2. Unless explicitly referred to as a plurality of battery control modules 2, the battery control module 2 may represent a plurality of battery control modules 2 or a single battery control module 2.

The battery control module 2 according to embodiments may be located outside the battery module 4. In one or more embodiments, the battery control module 2 may be separate from the battery module 4. The battery control module 2 may be on the frame front surface 32. The battery control module 2 may overlap the battery module 4 in a first direction (e.g., the x-axis direction). The first direction may represent a direction perpendicular to the height direction y.

According to embodiments, the battery module 4, the module bus bar 80, and the battery control module 2 may be arranged in the first direction (e.g., the x-axis direction) in this order. The module bus bar 80 may be between the battery control module 2 and the battery module 4. In one or more embodiments, the module bus bar 80 may be between the battery control module 2 and the battery module 4. However, the arrangement of the battery module 4, the module bus bar 80, and the battery control module 2 is not limited to that described above.

The battery pack 1 according to embodiments may include a battery management unit 70. The battery management unit 70 may be configured to selectively charge or discharge at least some of the plurality of battery modules 4. In one or more embodiments, the battery management unit 70 may select at least some of the battery modules 4 to be charged or discharged among the plurality of battery modules 4. The battery management unit 70 may be configured to control at least some of the plurality of battery control modules 2 so as to charge or discharge at least some of the battery modules 4. However, the functions of the battery management unit 70 are not limited to those described above. The battery management unit 70 may be on the frame 30. However, the arrangements of the battery management unit 70 are not limited to those described above.

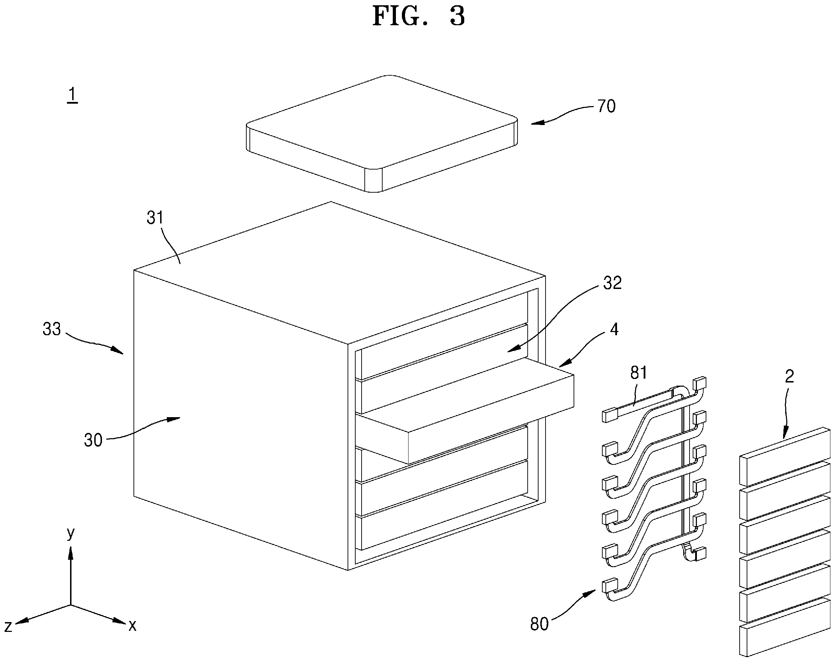

FIG. 3 is an exploded perspective view showing a process of replacing the battery module 4 in the battery pack 1 according to embodiments.

Referring to FIGS. 1 to 3, the battery module 4 according to embodiments may be separated (e.g., removed) from the battery pack 1. The battery module 4 may be separated (e.g., removed) from the frame 30. The battery module 4 may be detachably (e.g., removably) accommodated in the frame 30. The frame 30 may accommodate the battery modules 4 such that the battery modules 4 are detachable (e.g., removable) from the frame 30. After one battery module 4 is separated (e.g., removed) from the frame 30, another battery module 4 may be mounted on (e.g., inserted into or otherwise accommodated in) the frame 30. In one or more embodiments, the battery module 4 may be replaced in the battery pack 1 by detaching (e.g., removing) the battery module 4 from the frame 30.

The battery pack 1 according to embodiments may be configured such that the plurality of battery modules 4 may be individually replaced. Any battery module 4 among the plurality of battery modules 4 detachably (e.g., removably) accommodated in the frame 30 may be replaced independently from other battery modules 4.

The battery module 4 according to embodiments may be detached (e.g., removed) from the frame 30 in the first direction (e.g., the x-axis direction) perpendicular to the height direction y of the battery pack 1. In one or more embodiments, the battery module 4 may be separated (e.g., removed) in a direction toward the frame front surface 32. However, the direction in which the battery module 4 is detached (e.g., removed) is not limited to that described above.

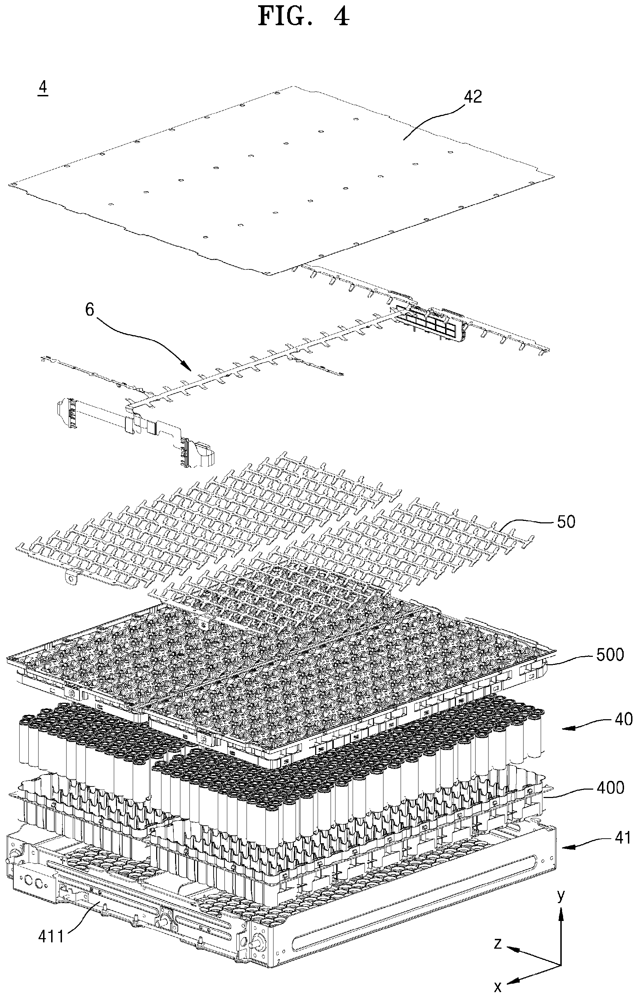

FIG. 4 is an exploded perspective view of the battery module 4 according to embodiments.

Referring to FIG. 4, the battery module 4 according to embodiments may include a plurality of battery cells 40. The plurality of battery cells 40 may include cylindrical batteries, but the embodiments are not limited thereto.

The battery module 4 according to embodiments may include a module housing 41 and a socket 400. The module housing 41 may form the exterior of the battery module 4. The module housing 41 may cover the plurality of battery cells 40. The module housing 41 may cover the socket 400. The socket 400 may fix the positions of the plurality of battery cells 40. The socket 400 may accommodate the plurality of battery cells 40 such that the positions of the plurality of battery cells 40 are fixed inside the module housing 41.

The battery module 4 according to embodiments may include a cell bus bar 50 and a bus bar mount 500. The cell bus bar 50 may electrically connect the plurality of battery cells 40 to each other. The bus bar mount 500 may be configured to fix the position of the cell bus bar 50.

The battery module 4 according to embodiments may include a controller 6. The controller 6 may be configured to control the electrical connection between the plurality of battery cells 40 arranged inside the battery module 4 and an external device located outside the battery module 4. The controller 6 may be electrically connected to the plurality of battery cells 40. The controller 6 may be electrically connected to the cell bus bar 50. However, the functions of the controller 6 are not limited to those described above.

The controller 6 according to embodiments may be accommodated in the battery module 4. The battery module 4 may accommodate the controller 6. An upper cover 42 for protecting the battery module 4 above the battery module 4 may cover the controller 6 from above. However, the arrangement of the controller 6 is not limited to that described above.

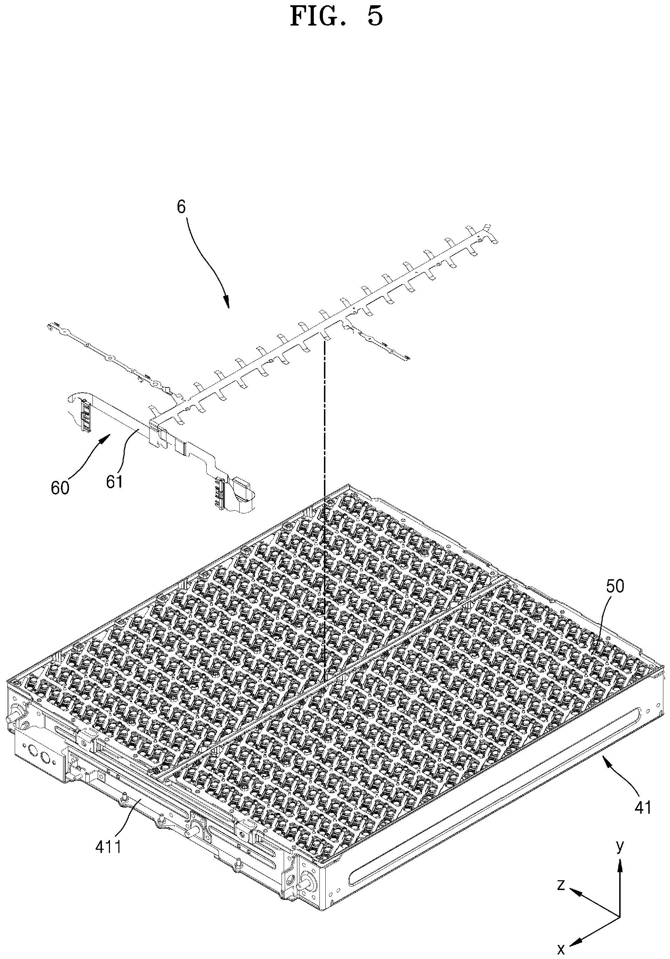

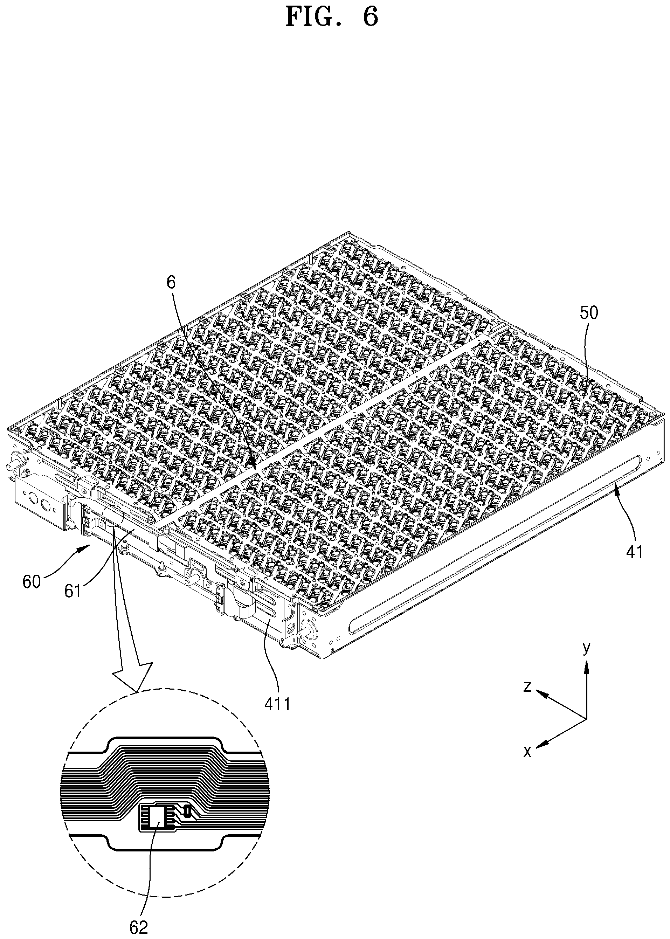

FIG. 5 is a diagram depicting the controller 6 according to embodiments. FIG. 6 is a diagram depicting the recording module 60 according to embodiments. FIG. 5 is an exploded view depicting a state in which the upper cover 42 of FIG. 4 is separated from the battery module 4 and the controller 6 is spaced upward. FIG. 6 depicts a state in which the controller 6 is mounted on the battery module 4.

Referring to FIGS. 4 to 6, the controller 6 according to embodiments may include the recording module 60. The recording module 60 may be configured to record the charging cycle of the battery module 4. The information about the charging cycle of the battery module 4 may be stored in the recording module 60. In one or more embodiments, the charging cycle of the battery module 4 may represent the number of times the battery module 4 is repeatedly charged and discharged. However, the method of deriving the charging cycle of the battery module 4 is not limited to that described above.

The recording module 60 according to embodiments may include a flexible circuit board 61. The flexible circuit board 61 may include a board that transmits power during the charging or discharging of the battery module 4. Through the flexible circuit board 61, the power may be transmitted between the plurality of battery cells 40 arranged inside the battery module 4 and an external device. The flexible circuit board 61 may be located on a housing front surface 411, but the embodiments are not limited thereto.

The recording module 60 according to embodiments may include a recording element 62 in which the information about the charging cycle of the battery module 4 is stored. The recording element 62 may be on the flexible circuit board 61, but the embodiments are not limited thereto.

Referring back to FIGS. 3, 5, and 6, the plurality of battery modules 4 according to embodiments may each include the recording element 62 configured to record the charging cycles of the respective battery module 4. The plurality of battery modules 4 may be configured to transmit information about the charging cycles, which are recorded in the recording elements 62, to the plurality of battery control modules 2, respectively. In one or more embodiments, each of the plurality of battery control modules 2 may obtain information about the charging cycle of the corresponding battery module 4 from the recording element 62 in the corresponding battery module 4.

If the recording element 62 according to embodiments has information about the charging cycle of the battery module 4, this may indicate that the battery module 4 itself has information about the charging cycle. The battery module 4 may have the information about the charging cycle independently of the corresponding battery control module 2. In one or more embodiments, even if the battery control module 2 corresponding to one battery module 4 is changed to another battery control module 2, the information about the charging cycle for this battery module 4 may not change.

In an embodiment in which the battery module 4 may record the charging cycle without using the battery control module 2, the information about the charging cycle may be maintained even after the battery control module 2 is replaced.

The battery module 4 according to embodiments may be configured to be detached from the frame 30 independently of the battery control module 2. The battery control module 2 may be separated (e.g., removed) from the battery pack 1 independently of the battery module 4. In one or more embodiments, the battery module 4 and the battery control module 2 may be independently separated (e.g., removed) from or coupled to the battery pack 1.

In an embodiment in which the battery module 4 may record the charging cycle without using the battery control module 2, the information about the charging cycle may be maintained without replacement of the battery control module 2 corresponding to the battery module 4 that is to be replaced.

The present disclosure may provide the battery pack that maintains information about the charging cycle of the battery module even after the battery control module has been replaced.

The present disclosure may provide the battery pack in which the battery module and the battery control module may be replaced independently of each other.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

1. A battery pack (1) comprising:
a plurality of battery modules (4), wherein the battery modules (4) are configured to be individually replaceable;
a frame (30) configured to accommodate the plurality of the battery modules (4); and
a battery control module (2) outside the plurality of battery modules (4) and configured to control charging and discharging of the plurality of battery modules (4),
wherein each battery module (4) of the plurality of battery modules (4) comprises a recording element (62) configured to record a charging cycle of the battery module (4).

2. The battery pack (1) as claimed in claim 1, wherein the battery modules (4) of the plurality of battery modules (4) are accommodated in the frame (30) and overlap each other in a height direction (y).

3. The battery pack (1) as claimed in claim 2, wherein the battery modules (4) of the plurality of battery modules (4) are accommodated in the frame (30) and are configured to be detachable from the frame (30) in a first direction (x) perpendicular to the height direction (y).

4. The battery pack (1) as claimed in claim 3, wherein each of the battery modules (4) is configured to transmit information about the charging cycle recorded in the recording element (62) to the battery control module (2).

5. The battery pack (1) as claimed in claim **4,** wherein the battery modules (4) of the plurality of battery modules (4) are configured to be detachable from the frame (30) independently of the battery control module (2).

6. The battery pack (1) as claimed in claim 5, wherein the battery control module (2) is on a front surface of the frame (30).

7. The battery pack (1) as claimed in claim 6, wherein the battery control module (2) overlaps the plurality of battery modules (4) in the first direction (x).

8. The battery pack (1) as claimed in claim 7, wherein the battery control module (2) comprises a plurality of battery control modules (2), and wherein the plurality of battery control modules (2) is electrically connected to the plurality of battery modules (4).

9. The battery pack (1) as claimed in claim 8, further comprising a module bus bar (80) configured to electrically connect the plurality of battery modules (4) to each other,
wherein the module bus bar (80) is arranged between the plurality of battery modules (4) and the plurality of battery control modules (2).

10. The battery pack (1) as claimed in any of claims 1 to 9, further comprising a battery management unit (70) configured to selectively charge or discharge at least some of the plurality of battery modules (4).

11. The battery pack (1) as claimed in claim 10, wherein the battery management unit (70) is on the frame (30).
